# EUROPEAN PATENT APPLICATION

(11) **EP 2 366 815 A1**
(43) Date of publication of application: **21.09.2011**
(21) Application number: 09825867.6
(22) Date of filing: 20.10.2009
(51) Int. Cl.: C30B 25/18, B32B 15/08, C23C 14/02, H01L 21/205

(54) **POLYMER LAMINATE SUBSTRATE FOR FORMATION OF EPITAXIALLY GROWN FILM, AND MANUFACTURING METHOD THEREFOR**

(30) Priority: 12.11.2008 JP 2008290343
(71) Applicant: Toyo Kohan Co., Ltd., Tokyo 102-8447 (JP)
(72) Inventor: OKAYAMA, Hironao, Kudamatsu-shi Yamaguchi 744-8611 (JP); NANBU, Kouji, Kudamatsu-shi Yamaguchi 744-8611 (JP); KANEKO, Akira, Kudamatsu-shi Yamaguchi 744-8611 (JP)
(74) Representative: Vossius & Partner
(86) International application number: PCT/JP2009/005473
(87) International publication number: WO 2010/055613

(57) **Abstract**

Disclosed are a polymer laminated substrate for forming an epitaxial growth film having a highly-crystal-oriented surface and a method of manufacturing the polymer laminated substrate. The method of manufacturing a polymer laminated substrate for forming an epitaxial growth film includes the steps of: activating at least one surface of a polymer sheet T1; activating at least one surface of a metal foil T2 which is made of Cu or a Cu alloy and is formed by cold rolling at a draft of 90% or more; laminating the polymer sheet and the metal foil such that an activated surface of the polymer sheet and an activated surface of the metal foil face each other in an opposed manner and applying cold rolling to the polymer sheet and the metal foil which are laminated to each other; and biaxially orienting crystals of the metal foil by heat treatment.

## Description

### Technical Field

The present invention relates to a polymer laminated substrate for forming an epitaxial growth film and a manufacturing method thereof.

### Background Art

Conventionally, as a substrate for forming an epitaxial growth film, a monocrystalline wafer made of monocrystalline silicon (Si), monocrystalline GaAs, monocrystalline sapphire (Al₂O₃) or the like having an excellent crystal orientation has been used.
However, the monocrystalline wafer made of these materials is a cut plate having a size of approximately 300mmφ at most, and such a monocrystalline wafer cannot be formed by a continuous manufacturing method such as a reel-to-reel method.
Further, also the strength of Si or the like is small and hence, the handling of the monocrystalline wafer made of Si or the like during the conveyance of the wafer in a manufacturing process is not easy whereby the careful handling of the wafer is necessary.
Further, the above-mentioned monocrystalline wafer cannot impart flexibility to a substrate and hence, applications where the substrate is used are limited.

Besides the above-mentioned monocrystalline wafer, as a substrate for forming an epitaxial growth film thereon, there have been known metal substrates having the high biaxial crystal orientation which are formed such that cold rolling is applied to a material made of Ni, Cu, Ag or an alloy of these metals at a high draft thus imparting a uniform strain to the whole material and, thereafter, the material is recrystallized by heat treatment.

Among these substrates, as disclosed in patent documents 1 to 5, there has been proposed a clad material made of Ni or an Ni-W alloy and another metal material. However, in these materials, an intermediate layer or a superconductor layer is formed at a high temperature of not lower than 600°C, saturated magnetization becomes low, and a surface is crystal-oriented to form a (200) surface and hence, the clad material is not popularly used whereby the clad material is a special and expensive material.
Patent document 1: Japanese patent 3601830
Patent document 2: Japanese patent 3587956
Patent document 3: WO2004/088677
Patent document 4: JP-A-2006-286212
Patent document 5: JP-A-2007-200831

### Disclosure of the Invention

### Problems that the Invention is to Solve

As has been explained heretofore, the monocrystalline wafer substrate for forming an epitaxial growth film has the following problems.
That is, an expensive monocrystalline substrate is used, the monocrystalline substrate is small in size, it is necessary to perform a single-wafer step treatment, the substrate is so hard that the substrate cannot possess the flexibility and hence, the number of applications where the substrate can be used is limited, and the like.
The present invention has been made to overcome the above-mentioned problems and it is an object of the present invention to provide a polymer laminated substrate for forming an epitaxial growth film having a highly-crystal-oriented surface and a method of manufacturing the polymer laminated substrate.

### Means for Solving the Problems

(1) A method of manufacturing a polymer laminated substrate for forming an epitaxial growth film according to the present invention is characterized in that a metal foil which is made of Cu or a Cu alloy and is formed by cold rolling at a draft of 90% or more is laminated to a polymer sheet and, after lamination, crystals of the metal foil are biaxially orientated by heat treatment.
(2) A method of manufacturing a polymer laminated substrate for forming an epitaxial growth film according to the present invention is characterized by including the steps of: activating at least one surface of a polymer sheet; activating at least one surface of a metal foil which is made of Cu or a Cu alloy and is formed by cold rolling at a draft of 90% or more; laminating the polymer sheet and the metal foil such that an activated surface of the polymer sheet and an activated surface of the metal foil face each other in an opposedmanner and applying cold rolling to the polymer sheet and the metal foil which are laminated to each other; and biaxially orienting crystals of the metal foil by heat treatment.
(3) A method of manufacturing a polymer laminated substrate for forming an epitaxial growth film according to the present invention is characterized by including the steps of: forming a metal layer on at least one surface of a polymer sheet by sputtering; activating at least one surface of a metal foil which is made of Cu or a Cu alloy and is formed by cold rolling at a draft of 90% or more; laminating the polymer sheet and the metal foil such that a surface of the metal layer of the polymer sheet and an activated surface of the metal foil face each other in an opposed manner and applying cold rolling to the polymer sheet and the metal foil which are laminated to each other; and biaxially orienting crystals of the metal foil by heat treatment.
(4) The method of manufacturing a polymer laminated substrate for forming an epitaxial growth film according to the present invention is, in the above-mentioned (1) or (2), characterized in that the cold rolling is performed at a draft of not more than 10% at the time of lamination.
(5) The method of manufacturing a polymer laminated substrate for forming an epitaxial growth film according to the present invention is, in any one of the above-mentioned (1) to (4), characterized in that the biaxial crystal orientation is performed in a state where the surface roughness of a metal-foil-side surface of the polymer sheet is adjusted to not less than 1nm and not more than 40nm in terms of Ra.
(6) The method of manufacturing a polymer laminated substrate for forming an epitaxial growth film according to the present invention is, in any one of the above-mentioned (1) to (5) , characterized in that a thickness of the metal foil is not less than 7µm and not more than 50µm.
(7) The method of manufacturing a polymer laminated substrate for forming an epitaxial growth film according to the present invention is, in any one of the above-mentioned (1) to (6), characterized in that the heat treatment is performed at a temperature of not lower than 150°C and not higher than 400°C.
(8) The method of manufacturing a polymer laminated substrate for forming an epitaxial growth film according to the present invention is, in any one of the above-mentioned (1) to (7) , characterized in that the metal foil contains not less than 0.01% and not more than 1% of Ag, Sn, Zn, Zr, O and N in total.
(9) The method of manufacturing a polymer laminated substrate for forming an epitaxial growth film according to the present invention is, in any one of the above-mentioned (1) to (8), characterized in that a protective film is further formed on a metal surface of the polymer laminated substrate which is manufactured by the method of manufacturing a polymer laminated substrate.
(10) A polymer laminated substrate for forming an epitaxial growth film according to the present invention is characterized by being manufactured by any one of the methods of manufacturing a polymer laminated substrate for forming an epitaxial growth film according to any one of the abode-mentioned (1) to (9).

### Advantageous effects of the Invention

In the polymer laminated substrate for forming an epitaxial growth film according to the present invention, the substrate is made of polymer and hence, the substrate possesses flexibility. Further, the substrate has a highly-crystal-oriented surface and hence, the substrate is excellent as a substrate for forming an epitaxial growth film.

### Best Mode for Carrying Out the Invention

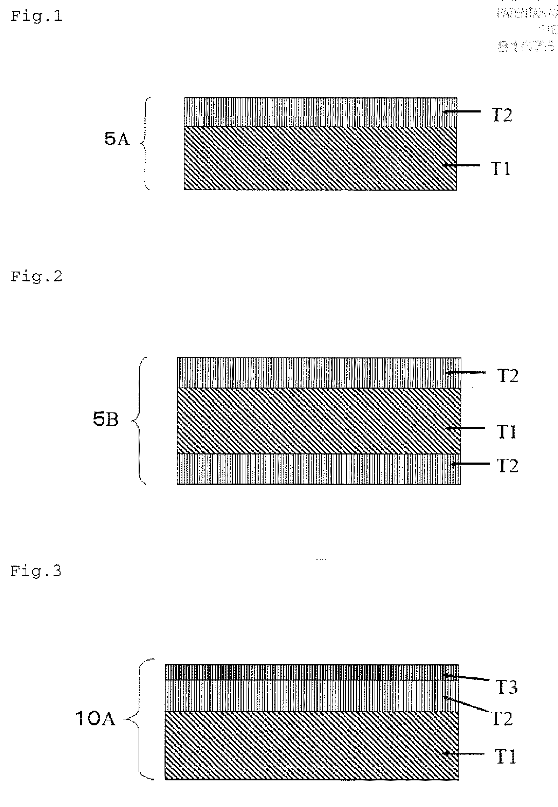

Fig. 1 is a schematic cross-sectional view showing the constitution of a polymer laminated substrate 5A for forming an epitaxial growth film according to the present invention.
As shown in Fig. 1, the polymer laminated substrate 5A is constituted of a polymer sheet T1, and a metal foil T2 which is laminated to the polymer sheet T1.
Although the polymer sheet T1 is selected depending on a use purpose thereof, a polymer sheet which can endure a recrystallizing heat treatment temperature of 150°C to 400°C of the metal foil to be laminated can be used. As such a polymer sheet, particularly, a resin film made of polyimide, liquid crystal polymer, aramid or the like which exhibits excellent heat resistance and has been popularly used is given as an example because of the excellent heat resistance under high temperature.

A thickness of the polymer sheet T1 is not limitedprovided that the polymer sheet T1 can secure strength and can be offered in a state of wide and elongated coil state. However, to take a cost and widespread aramid films, polyimide films and liquid crystal polymer films into consideration, the polymer sheet having a thickness of not less than 3µm and not more than 200µm is desirable.

As a preferable material of the metal foil T2, a Cu foil or a Cu alloy foil (both the Cu foil and the Cu alloy foil also referred to as a Cu alloy foil in this specification) are given as examples.
Although the Cu alloy foil T2 may be used in a state where crystals are oriented by heat treatment in advance, in view of the danger that strain occurs in the Cu alloy foil T2 during handling so that crystal orientation is deteriorated, it is desirable to impart high crystal orientation to the Cu alloy foil T2 after forming a polymer laminated substrate by laminating the Cu alloy foil T2 to the polymer sheet T1.

Accordingly, it is desirable to maintain the Cu alloy foil T2 of the present invention in a uniform rolled texture state formed by severe working at a draft of not less than 90% before the Cu alloy foil T2 is laminated to the polymer sheet T1.
This is because when the draft is less than 90%, there exists a possibility that Cu is not oriented in the heat treatment which is performed after working.

Such a high-reduction rolled Cu alloy foil has been developed for imparting high bending property to the foil aiming at the use in a flexible printed circuit board, has been widespread, and can be easily obtained.
For example, a high-reduction rolled Cu foil (product name: HA foil) made by Nikko Materials Ltd, a high-reduction rolled Cu foil (product name: HX foil) made by Hitachi Electric Wires., Ltd and the like are given as examples.

In the present invention, it is desirable to use the above-mentioned commercially available high-reduction rolled Cu alloy foils since these foils exhibit the excellent crystal orientation.
It is desirable to use the metal foil having a thickness of not less than 7µm and not more than 50µm, and it is more desirable to use the metal foil having a thickness of not less than 12µm and not more than 18µm. The reason the thickness of the metal foil is set to not less than 7µm is to secure strength of the Cu alloy foil T2, and the reason the thickness of the metal foil is set to not more than 50µm is to secure workability of the Cu alloy foil T2.

With respect to the crystal orientation of the Cu alloy foil T2, by setting a temperature of the polymer laminated substrate at a temperature of not lower than 150°C at the time of bonding the Cu alloy foil T2 to the molecular sheet T1 or in a step of forming a targeted epitaxial growth filmafterbonding, the Cu alloy foil is recrystallized at the time of bonding the Cu alloy foil T2 to the molecular sheet T1 or in the step of forming the targeted epitaxial growth film and hence, the high crystal orientation can be imparted to the Cu alloy foil.

However, when the treatment of the polymer laminated substrate is performed at a temperature lower than 150°C at the time of bonding the Cu alloy foil T2 to the molecular sheet T1 or in the step of forming the targeted epitaxial growth film after bonding or when a treatment time in continuous steps is short although the Cu alloy foil T2 passes the step at a temperature of not lower than 150°C, the recrystallization of the Cu alloy foil is suppressed so that the high crystal orientation cannot be imparted to the Cu alloy foil T2. Accordingly, it is preferable to impart the crystal orientation to the Cu alloy foil on the polymer laminated substrate by heat treatment in advance.

It is sufficient that the heat treatment temperature is not lower than a temperature at which the recrystallization of the Cu alloy foil is completed. However, to take conditions such as the bonding counterpart being the polymer sheet, the heat resistance of the polymer sheet and the crystal orientation of the Cu alloy film being set to a high orientation rate of not less than 99% and the like into consideration, it is desirable to set the heat treatment temperature to a temperature of not lower than 150°C and not higher than 400°C.

Although any element may be used as an element to be added to the Cu alloy foil provided that the element allows the Cu alloy foil to easily elevate a (200) surface crystal orientation rate to not less than 99% by heat treatment, trace amounts of Ag, Sn, Zn, Zr, O, N are added to the Cu alloy foil respectively, wherein a total amount of these elements is set to not less than 0.01% and not more than 1%.
The reason the total amount of elements to be added is set to not more than 1% is that although the elements to be added and Cu form a solid solution, when the total amount of elements to be added exceeds 1%, there exists a possibility that impurities such as oxides other than solid solution are increased and the impurities influence the orientation.
Accordingly, it is preferable to set the total amount of elements to be added to not less than 0.01% and not more than 0.1%.

The polymer laminated substrate is completed by bonding the polymer sheet and the Cu alloy foil explained above to each other.
Fig. 2 shows a polymer laminated substrate 5B according to an embodiment where a metal foil T2 is bonded to both surfaces of the polymer sheet T1.
In the polymer laminated substrate 5B shown in Fig. 2, a crystal oriented metal layer is laminated to both surfaces of the flexible polymer sheet T1 and hence, it is possible to form a substrate which can form an epitaxial growth film on both surfaces thereof.

As a method of bonding the polymer sheet and the Cu alloy foil, any means may be adopted provided that a wide and elongated coil can be bonded uniformly in the longitudinal direction. As such a means, a means in which the polymer sheet and the Cu alloy foil are pressure-bonded to each other using an adhesive agent by allowing the polymer sheet and the Cu alloy foil to pass between two rolls, a casting method in which the polymer sheet and the Cu alloy foil are directly bonded to each other without using an adhesive agent or the like can be given as examples.
Further, it is also preferable to adopt a surface activation bonding method by which the stable crystal orientation can be obtained also after bonding.

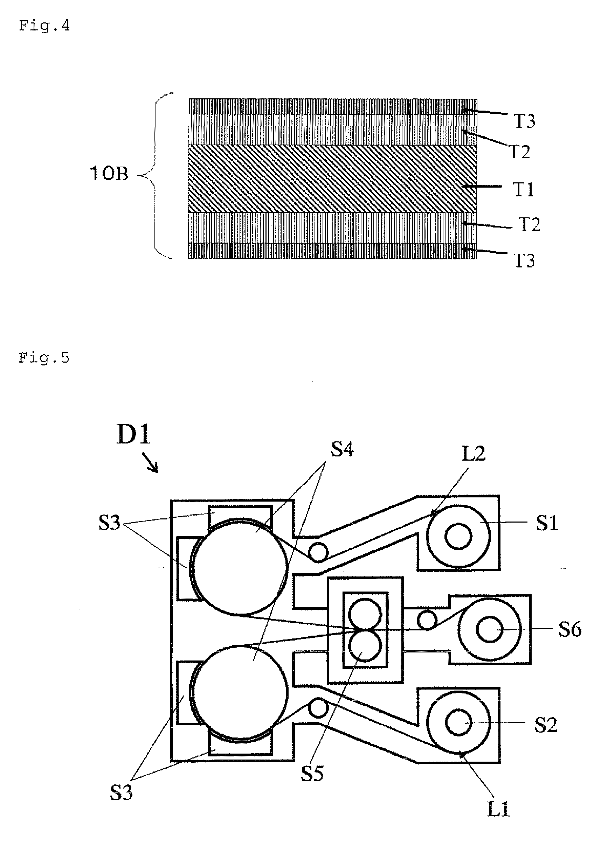

As the above-mentioned surface activation bonding method, for example, a vacuum surface activation bonding device D1 shown in Fig. 5 and Fig. 6 can be used. The surface activation bonding means that surfaces of a polymer sheet to be laminated and a metal foil to be laminated are activated by removing oxide, dirt and the like on the surfaces using a method such as sputter etching, the activated surfaces are brought into contact with each other and the laminate is subjected to cold rolling. Further, a metal layer may be provided to the surface of the polymer sheet by sputtering.
As shown in Fig. 5, a polymer sheet 24 and a Cu alloy foil 26 are prepared as elongated coils having a width of 150mm to 600mm, and are mounted on recoiler portions 62, 64 of the surface activation bonding device D1.
The polymer sheet 24 and the Cu alloy foil 26 which are conveyed from the recoiler portions 62, 64 are continuously conveyed to a surface activation treatment step where activation treatment is applied to two surfaces to be bonded in advance and, thereafter, the polymer sheet 24 and the Cu alloy foil 26 are brought into pressure contact with each other by cold roll ing.

In the surface activation treatment step, the surface activation treatment is performed by sputter etching treatment in an extremely-low-pressure inert gas atmosphere of 10 to 1×10⁻²Pa, wherein the polymer sheet 24 and the Cu alloy foil 26 having bonding surfaces are used as one electrodes A (72, 82) which are connected to aground respectively, aglow discharge is generated by applying an AC current of 1 to 50MHz between one electrodes A and the other electrodes B (74, 76 and 84, 86) which are supported in an insulated manner, and an area of the electrode which is exposed in plasma generated by the glow discharge is not more than 1/3 of an area of the electrodes B. As an inert gas, argon, neon, xenon, krypton or a mixture gas containing at least one kind selected from a group consisting of these gases is applicable.

In the sputter etching treatment, surfaces of the polymer sheet 24 and the Cu alloy foil 26 which are bonded to each other are subjected to sputtering by an inert gas so that surface absorption layers and surface oxide films are removed whereby the bonding surfaces are activated. During this sputter etching treatment, the electrodes (72, 82) take the form of cooling rolls thus preventing the elevation of temperatures of respective materials to be conveyed.

Thereafter, the polymer sheet 24 and the Cu alloy foil 26 are continuously conveyed to a pressure bonding roll step (60) so that the activated surfaces are pressure-bonded to each other. When an O₂ gas or the like exists in the pressure bonding atmosphere, the activation processed surfaces are oxidized again during the conveyance and hence, the pressure bonding atmosphere influences the close contact between the polymer sheet 24 and the Cu alloy foil 26. Accordingly, it is desirable to perform the pressure bonding roll step (60) under a high vacuum of 1×10⁻³Pa or less. Further, the lower a draft, the more excellent the accuracy in thickness becomes and hence, it is preferable to set the draft to not more than 10% for preventing the collapse of a state of the metal foil, and it is more preferable to set the draft to not more than 2%.

A laminated body formed by bonding the polymer sheet 24 and the Cu alloy foil 26 to each other with in a close contacting manner through the above-mentioned pressure bonding step is conveyed to a winding step (66), and is wound in the step.

Further, regarding electrode C (76), as shown in Fig.6, to enhance the close contact between the polymer sheet and the Cu alloy foil, it is also effective to form a metal intermediate layer on a bonding-surface side of the polymer sheet by etching the polymer sheet at the electrode B (74), by arranging a target (90) made of Ni, an Ni-Cr alloy, an Ni-Cu alloy or the like, and by applying reverse voltages to electrode (B).

Here, as shown in Fig. 3, when the adhesiveness cannot be secured in forming a target material on the Cu alloy foil or when it is difficult to directly form the target material on Cu by an epitaxial growth, a protective film can be formed on the polymer laminated substrate as an intermediate layer.
For example, in forming a GaN film made of a semiconductor compound as an epitaxial growth film for forming a blue light emitting diode, an InGaN layer or a ZnO layer is formed on the Cu alloy foil as a protective film, and the GaN film is formed on the protective film.
It is sufficient that a thickness of the protective film is set to not less than 0.1µm to prevent the diffusion of Cu in a background material. Further, the thickness of the protective film is preferably set to not more than 10µm to maintain an epitaxial growth film.
As a method of forming the protective film, a sputtering method, a vapor deposition method, a CVD method, a MOCVD method, an electrolytic plating method, a non-electrolytic plating method and the like are considered. However, any method can be used. When the protective film is made of metal such as Ni, it is economically preferable to use an electrolytic plating method. Further, when the protective film is formed of an oxide or a nitride, it is preferable to use a sputtering method or a MOCVD method in which the protective film can be formed at a relatively low substrate temperature.

Further, Fig. 4 shows a polymer laminated substrate 10B according to an embodiment in which the metal foil T2 is bonded to both surfaces of the polymer sheet T1, and a protective film T3 is formed on the respective metal foils T2.
In the polymer laminated substrate 10B shown in Fig. 4, a crystal-oriented metal layer is laminated to both surfaces of the flexible polymer sheet T1, and the protective film T3 is formed on the respective metal foils T2 and hence, the polymer laminated substrate 10B is formed of a substrate which forms an epitaxial growth film on both surfaces thereof.

As a means for forming the epitaxial growth film, a known means such as an electrolytic plating method, a non-electrolytic plating method, a vacuum vapor deposition method or a sputtering film forming method can be used.

It is necessary to form the epitaxial growth film by an epitaxial growth and it is desirable to set a film thickness of the epitaxial growth film to not less than 1nm and not more than 10µm.
This is because when the film thickness of the epitaxial growth film is less than 1nm, the adhesiveness cannot be secured although the epitaxial growth film is formed, while when the film thickness exceeds 10µm, a film thickness of the epitaxial growth film becomes excessively large.

Next, the explanation is made with respect to the surface roughness of a Cu alloy foil whose crystals are oriented on the polymer laminated substrate.
Although there arises no problem when the surface roughness of the Cu alloy foil at the time of purchasing is not more than 40nm in terms of surface roughness Ra, there may be a case where the surface roughness Ra of the Cu alloy foil at the time of purchasing exceeds 1.00nm.

Even when the surface roughness (indicating an average surface roughness) Ra of the Cu alloy foil is 100nm, the substrate exhibits the sufficient performance. However, the lower the surface roughness Ra, the more the crystal orientation is improved. Accordingly, when a surface roughness state of the Cu alloy foil is 100nm in terms of Ra, after surface activation bonding, the treatment which adjusts the surface roughness Ra to not more than 40nm is performed.

As a method of lowering the surface roughness, the rolling reduction using pressure rolls, buffing, electrolytic polishing, electrolytic abrasive grain polishing and the like are considered. However, any method can be used. Although it is desirable to set the surface roughness to a mirror surface level, by taking a currently available technique and an economic aspect into consideration, it is desirable to set the surface roughness Ra to not less than 1nm and not more than 10nm.

By performing the above-mentioned surface roughness adjustment, it is possible to acquire a polymer laminated substrate for forming a more excellent epitaxial growth film and hence, a high-performance functional film can be formed on the substrate.

By manufacturing the polymer sheet for forming an epitaxial growth film as described above, the Cu metal foil can be laminated to the polymer sheet with an interface formedbetween the Cu metal foil and the polymer sheet made smooth while maintaining a state where the Cu metal foil is cold-rolled at a high draft. This is because, in biaxially orienting crystals of the metal foil by heating after such cold rolling, when a state where the Cu metal foil is cold-rolled at a high draft is not maintained, required biaxial crystal orientation is not generated. Further, when the interface is not smooth, there exists a possibility that the biaxial crystal orientation collapses.
Further, when the Cu metal foil is laminated using the surface active bonding method, there is small possibility that the Cu metal foil is deformed or the like by heating after the lamination and hence, a possibility that the biaxial crystal orientation collapses is lowered. Accordingly, the above-mentioned laminating method is more effective compared to a lamination method which uses an adhesive agent or the like.

### Embodiment 1

Hereinafter, an embodiment of the present invention is exemplified, wherein properties of the obtained polymer laminated substrate are explained.
A high-reduction rolled Cu foil having a width of 200mm and a thickness of 18µm, a polyimide film having a thickness of 25µm, and a liquid crystal polymer film are bonded to each other by a room-temperature surface activation bonding method and, thereafter, thehigh-reductionrolledCufoil, the polyimide film and the liquid crystal polymer film are subjected to heat treatment at a temperature of 200°C for five minutes thus obtaining the polymer laminated substrate.
With respect to such a polymer laminated substrate, Table 1 shows a rate at which a Cu (200) surface is arranged parallel to a Cu foil surface, that is, a crystal orientation rate (a diffraction peak strength rate of a (200) surface at a θ/2θ diffraction peak measured by X-ray diffraction: I₍₂₀₀₎/ΣI₍ₕₖₗ₎ X100(%)), and a Δφ° which is a biaxial orientation index (φ scan peak (an average value of half value widths of 4 peaks at α=35°) obtained by an Ni(111) pole figure in accordance with X-ray diffraction) which indicates that the (200) surface is parallel to the longitudinal direction <001>.
As comparison examples, a peak strength rate when the heat treatment is performed at a temperature of 13 ooh and a peak strength rate when a rolled Cu foil having a thickness of 16µm which is subjected to general rolling which is not performed at a high draft is bonded by the above-mentioned room-temperature activation bonding method and, thereafter, heat treatment is performed at a temperature of 200°C for five minutes are shown.

As can be understood from Table 1, in the high-reduction rolled Cu foil, irrespective of a kind of a laminated polymer sheet, the crystal orientation rate is 93% when the heat treatment is per formed at a heat treatment temperature of 130°C for 5 minutes and hence, the crystal orientation rate is not sufficient yet. However, when such heat treatment temperature is held at 200°C for 5 minutes, the (200) surface crystal orientation rate becomes 99% or more.
On the other hand, when the usual rolled Cu foil shown as the comparison example is used, the crystal orientation rate is not more than 70% even after the heat treatment.
Further, Δφ of the embodiment where the crystals are oriented at the crystal orientation rate of not less than 99% is 6° thus exhibiting the considerably high biaxial crystal orientation.

**[Table 1]**

| Example | Sample | Heat treatment temperature (°C) | Crystal orientation rate (%) | Δφ (°) |
|---|---|---|---|---|
| Comparison example 1-1 | General Cu foil/polyimide | 200 | 65.0 | Not measured |
| Comparison Example 1-2 | General Cu foil/liquid crystal polymer | 200 | 66.0 | Not measured |
| Comparison Example 1-3 | High-reduction Cu foil/polyimide | 130 | 93.0 | Not measured |
| Embodiment 1-1 | High-reduction Cu foil/liquid crystal polymer | 200 | 99.8 | 6.0 |
| Comparison Example 1-4 | High-reduction Cu foil/liquid crystal polymer | 130 | 93.0 | Not measured |
| Embodiment 1-2 | High-reduction Cu foil/polyimide | 200 | 99.8 | 6.0 |

Here, the measured value described above is an average of values measured at three points consisting of areas in the vicinity of both ends of the plate and the center of the plate having a size of 200mm in the widthwise direction, and no difference is substantially recognized with respect to the value in the width direction among the embodiments.

The polymer laminated substrates according to the present invention can be manufactured as a wide and elongated coil while maintaining the uniform crystal orientation in a surface of the Cu foil and hence, the use of the polymer laminated substrates as substrates for various epitaxial growth films canbe expected.

As a method of forming the epitaxial growth film, a plating method, a physical vapor deposition (PVD) method, a chemical vapor deposition (CVD) method, a molecular beam (MBE) method and the like can be named.

The above-mentioned method of forming an epitaxial growth film has been steadily developed year by year. For example, with respect to the CVD method, in place of a method in which a film is formed by elevating a substrate temperature to 400 to 800°C, a method in which a film can be formed at a substrate temperature of approximately 200°C using RF plasma has been developed so that a low-temperature formed film such as a polycrystalline Si film, a GaN film or the like can be formed.

Due to the above-mentioned low-temperature film forming technique, the polymer laminated substrate according to the present invention can be used as substrates for various epitaxial growth films such as a solar-cell-use polycrystalline silicon (Si) film, alight-emitting-diode-use galliumnitride (GaN) film, a TiO₂ film by which a photocatalytic effect, a photoelectric effect or the like can be expected.

### Industrial applicability

According to the method of manufacturing a polymer laminated substrate for forming an epitaxial growth film of the present invention, a continuous film forming step can be performed by a reel-to-reel method using an elongated coil.
Further, the method can contribute to the crystal orientation of a polycrystalline silicon film for forming a solar cell, the reduction of weight of the polycrystalline silicon film, imparting of flexibility to the polycrystalline silicon film, the reduction of cost of a GaN element for forming a light emitting diode and the like. Accordingly, the polymer laminated substrate can be used as a new material for forming an epitaxial growth film in new fields where the utilization of the metal laminated substrate has not been studied and hence, the present invention is industrially extremely useful.

### Brief explanation of drawing

[Fig. 1]
   A schematic cross-sectional view showing the constitution of a polymer laminated substrate 5A according to an embodiment of the present invention.
[Fig. 2]
   A schematic cross-sectional view showing the constitution of a polymer laminated substrate 5B according to an embodiment of the present invention.
[Fig. 3]
   A schematic cross-sectional view showing the constitution of a polymer laminated substrate 10A according to an embodiment of the present invention.
[Fig. 4]
   A schematic cross-sectional view showing the constitution of a polymer laminated substrate 10B according to an embodiment of the present invention.
[Fig. 5]
   A schematic view of a surface activation bonding device D1.

### Explanation of symbols

- T1:: polymer sheet
- T2:: Cu foil or Cu alloy foil
- T3:: protective film
- 5A, 5B, 10A, 10B:: polymer laminated substrate

## Claims

1. A method of manufacturing a polymer laminated substrate for forming an epitaxial growth film, wherein a metal foil which is made of Cu or a Cu alloy and is formed by cold rolling at a draft of 90% or more is laminated to a polymer sheet and, after lamination, crystals of the metal foil are biaxially orientated by heat treatment.

2. Amethodof manufacturing a polymer laminated substrate for forming an epitaxial growth film comprising the steps of:
activating at least one surface of a polymer sheet;
activating at least one surface of a metal foil which is made of Cu or a Cu alloy and is formed by cold rolling at a draft of 90% or more;
laminating the polymer sheet and the metal foil such that an activated surface of the polymer sheet and an activated surface of the metal foil face each other in an opposedmanner and applying cold rolling to the polymer sheet and the metal foil which are laminated to each other; and
biaxially orienting crystals of the metal foil by heat treatment.

3. A method of manufacturing a polymer laminated substrate for forming an epitaxial growth film comprising the steps of:
forming a metal layer on at least one surface of a polymer sheet by sputtering;
activating at least one surface of a metal foil which is made of Cu or a Cu alloy and is formed by cold rolling at a draft of 90% or more;
laminating the polymer sheet and the metal foil such that a surface of the metal layer of the polymer sheet and an activated surface of the metal foil face each other in an opposed manner and applying cold rolling to the polymer sheet and the metal foil which are laminated to each other; and
biaxially orienting crystals of the metal foil by heat treatment.

4. The method of manufacturing a polymer laminated substrate for forming an epitaxial growth film according to claim 2 or 3, wherein the cold rolling is performed at a draft of not more than 10% at the time of lamination.

5. The method of manufacturing a polymer laminated substrate for forming an epitaxial growth film according to any one of claims 1 to 4, wherein the biaxial crystal orientation is performed in a state where the surface roughness of a metal-foil-side surface of the polymer sheet is adjusted to not less than 1nm and not more than 40nm in terms of Ra.

6. The method of manufacturing a polymer laminated substrate for forming an epitaxial growth film according to any one of claims 1 to 5, wherein a thickness of the metal foil is not less than 7µm and not more than 50µm.

7. The method of manufacturing a polymer laminated substrate for forming an epitaxial growth film according to any one of claims 1 to 6, wherein the heat treatment is performed at a temperature of not lower than 150°C and not higher than 400°C.

8. The method of manufacturing a polymer laminated substrate for forming an epitaxial growth film according to any one of claims 1 to 7, wherein the metal foil contains not less than 0.01% and not more than 1% of Ag, Sn, Zn, Zr, O and N in total.

9. The method of manufacturing a polymer laminated substrate for forming an epitaxial growth film according to any one of claims 1 to 8, wherein a protective film is further formed on a metal surface of the polymer laminated substrate which is manufactured by the method of manufacturing a polymer laminated substrate.

10. A polymer laminated substrate for forming an epitaxial growth film manufactured by any one of the methods of manufacturing a polymer laminated substrate for forming an epitaxial growth film according to any one of claims 1 to 9.
